# EUROPEAN PATENT SPECIFICATION

(11) **EP 1 816 175 B1**
(45) Date of publication and mention of the grant of the patent: **14.10.2009**
(21) Application number: 07001862.7
(22) Date of filing: 29.01.2007
(51) Int. Cl.: C09J 9/02, H01L 21/58, H01L 23/373

(54) **Thermal interface material**
Thermisches Zwischenmaterial
Matériel d'interface thermique

(30) Priority: 30.01.2006 US 275786
(43) Date of publication of application: 08.08.2007
(73) Proprietor: Henkel AG & Co. KGaA, 40589 Düsseldorf (DE)
(72) Inventor: Collins, Andrew, Bedford New Hampshire 03110 (US); Cheng, Chih-Min, Westford Massachusetts 01886 (US)
(74) Representative: Held, Stephan

(56) References cited:
- EP-A- 1 503 413
- JP-A- 2000 129 215
- JP-A- 2004 043 673
- US-A- 5 288 769
- US-A1- 2004 206 943

## Description

### FIELD OF THE INVENTION

This invention relates to a thermally conductive material that is utilized to transfer heat from a heat-generating electronic device to a cold sink that absorbs and dissipates the transferred heat.

### BACKGROUND OF THE INVENTION

Electronic devices, such as those containing semiconductors, typically generate a significant amount of heat during operation. In order to cool the semiconductors, cold sinks are typically affixed in some manner to the device. In operation, heat generated during use is transferred from the semiconductor to the cold sink where the heat is harmlessly dissipated. In order to maximize the heat transfer from the semiconductor to the cold sink, a thermally conductive thermal interface material is utilized. The thermal interface material ideally provides an intimate contact between the cold sink and the semiconductor to facilitate the heat transfer. Commonly, either a paste-like thermally conductive material, such as silicone grease, or a sheet-like thermally conductive material, such as silicone rubber is utilized as the thermal interface material.

The current phase change materials, greases, pastes and pad thermally conductive materials have drawbacks that present obstacles during their use. For example, while some pastes and greases provide low thermal resistance, they must be applied in a liquid or semi-solid state and thus require manufacturing controls in order to optimize their application. In addition to enhanced controls during application, the handling of the paste or grease materials can be messy and difficult. Further, greases and pastes are not capable of utilization on non-planar surfaces. Additional difficulties in utilizing existing materials include controls upon reapplication for pastes, migration of grease to unwanted areas, and reworkability for phase change materials or thermoset pastes. Traditional thermal interface pads address the handling and application problems of pastes and greases, however they typically have a higher thermal resistance as compared to pastes and greases. Thus, it would be advantageous to provide a thermal interface material that is easy to handle and apply, yet also provides a low thermal resistance.

Document EP 1 503 413 A2 discloses a thermally conductive composition for transferring heat.

### SUMMARY OF THE INVENTION

A composition for use as a thermal interface material in a heat-generating, semiconductor-containing device is provided. The composition is as described in claim 1.

Another aspect of the present invention provides electronic devices according to claims 14 and 15.

### BRIEF DESCRIPTION OF THE DRAWING

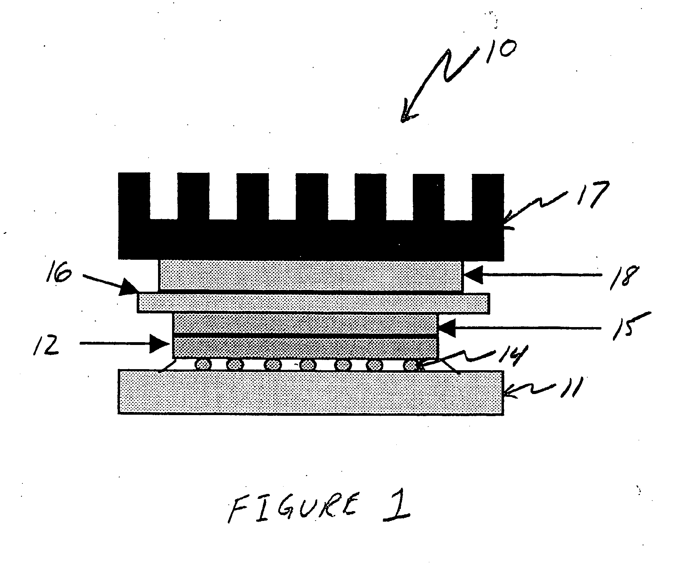

Figure 1 is a side view of an electronic component having a cold sink and thermal interface material.

### DETAILED DESCRIPTION OF THE PREFERRED EMBODIMENTS

The thermal interface material of the present invention may be utilized with virtually any heat-generating component for which it is desired to dissipate the heat. In particular, the thermal interface material is useful for aiding in the dissipation of heat from heat-generating components in semiconductor devices. In such devices, the thermal interface material forms a layer between the heat-generating component and the cold sink and transfers the heat to be dissipated to the cold sink. The thermal interface material may also be used in a device containing a heat spreader. In such a device, a layer of thermal interface material may be placed between the heat-generating component and the heat spreader and a second layer, which is usually thicker than the first layer, may be placed between the heat spreader and the cold sink.

The thermal interface material comprises a blend of an acrylic polymer film forming material, one or more liquid resins, thermally conductive particles, optionally one or more solid resins and other additives to increase the heat transport beyond the base formulation. Depending upon the composition it may be desirable to form the films via hot melt extrusion. Preferably the material is blended such the material retains its properties under accelerated stress testing.

The acrylic polymer component of the composition is primarily utilized as a film forming composition. The acrylic polymer is compatible with polar chemistries and have a good affinity for the substrate and fillers. The acrylic copolymer of the invention is soluble in coating solvent and thus enables a low stress, high strength film forming or paste adhesive. The preferred acrylic copolymer is a saturated polymer and thus resistant to oxidation, aging and deterioration. The composition of the copolymer is butyl acrylate-ethyl acrylonitrile or butyl acrylate-co-ethyl acrylonitrile or ethyl acrylate-acrylonitrile to provide high molecular weight polymerization. The copolymer preferably has hydroxyl, carboxylic acid, isocyanate or epoxy functionality to improve the solvent and epoxy compatibility. The molecular weight of the copolymer is high and preferably in the range of about 200,000 to about 900,000. The glass transition temperatures (Tg) of the copolymer are low relative to room temperature and preferably within the range of about 30°C to about -40°C. While various functional acrylic copolymers may be utilized, a preferred functional acrylic copolymer is TEISAN RESIN SG80H, commercially available from Nagase ChemteX Corporation of Osaka, Japan.

The liquid resin component, and optional solid resin component, of the composition acts to wet the interface surfaces and enhance the heat conductivity. The preferred resins for use with the present invention include epoxy resins such as monofunctional and multifunctional glycidyl ethers of Bisphenol-A and Bisphenol-F, aliphatic and aromatic epoxies, saturated and unsaturated epoxies, or cycloaliphatic epoxy resins or a combination thereof. A most preferred epoxy resin is bisphenol A type resin. These resins are generally prepared by the reaction of one mole of bisphenol A resin and two moles of epichlorohydrin. A further preferred type of epoxy resin is epoxy novolac resin. Epoxy novolac resin is commonly prepared by the reaction of phenolic resin and epichlorohydrin. Additional epoxy resins that may be utilized include, but are not limited to, dicyclopentadiene-phenol epoxy resin, naphthalene resins, epoxy functional butadiene acrylonitrile copolymers, epoxy functional polydimethyl siloxane, epoxy functional copolymers, 3,4-epoxycyclohexylmethyl-3,4-epoxycyclohexane carboxylate, vinylcyclohexene dioxide, 3,4-epoxy-6-methyl cyclohexyl methyl-3,4-epoxycyclohexane carboxylate, dicyclopentadiene dioxide, poly(phenyl glycidyl ether)-co-formaldehyde, biphenyl type epoxy resin, dicyclopentadiene-phenol epoxy resins, naphthalene epoxy resins, epoxy functional butadiene acrylonitrile copolymers, epoxy functional polydimethyl siloxane, and mixtures thereof. Commercially available bisphenol-F type resin is available from CVC Specialty Chemicals, Maple Shade, New Jersey, under the designation 8230E and Resolution Performance Products Ltd. under the designation RSL1739. Bisphenol-A type epoxy resin is commercially available from Resolution Performance Products Ltd. as EPON 828, and a blend of bisphenol-A and bisphenol-F is available from Nippon Chemical Company under the designation ZX-1059. Additional liquid and solid resins that may be utilized include phenolic, acrylic, silicone, polyol, amine, rubber based, phenoxy, olefin, polyester, isocyanate, cyanate ester, bismaleimide chemistry and mixtures thereof.

In addition to the acrylic polymer and resin, the thermal interface material further comprises thermally conductive particles. These particles may be either electrically conductive or non-conductive. The material comprises in the range of 50 to 95 wt % conductive particles. The conductive particles may comprise any suitable thermally conductive material, including silver, gold, nickel, copper, metal oxides, boron nitride, alumina, magnesium oxides, zinc oxide, aluminum, aluminum oxide, aluminum nitride, silver-coated organic particles, silver plated nickel, silver plated copper, silver plated aluminum, silver plated glass, silver flakes, carbon black, graphite, boron-nitride coated particles and mixtures thereof. Preferably, the conductive particles are boron nitride.

The combination of the acrylic polymer and the resin should be chosen, if so desired, to produce a material having sufficient integrity to be a solid at room temperature and properties of a low viscosity material. Thus, the resulting material will be suitable for use as a tape or film and will provide good surface wetting. The material is capable of wetting substrates with high surface energy, such as metals, and low surface energy, such as plastics. Further, due to the combination of the acrylic polymer and resin, the resulting material is reworkable and can be easily removed from a substrate after application without the use of solvent or heat. This property is unique as compared to other thermal interface materials that offer low thermal resistance. The thermal interface materials of the present invention are also unique in that they provide a thin film with low thermal resistance. In contrast, grease thermal interface materials provide low thermal resistance, but require dispensing or screen/stencil printing. A further benefit of the thermal interface materials of the present invention is that they are reworkable without heat or solvents, thus allowing reworking in any location. Typically, the use of this material would require external support, such as clamping. Finally, in the form of a film the thermal interface material of the present invention will not flow to any unwanted areas of the substrate to which it is being applied. In addition, a pressure sensitive adhesive may be applied to the film in order to provide sufficient tack to hold the film in position during application. If desired, the material may also be in the form of a paste.

An acrylate may optionally be added utilized primarily to enhance compressibility and for ease of handling and elongation of the material. A preferred acrylate is NIPOL AR-14, commercially available from Zeon Chemical.

The thermal interface materials may be cured with numerous known materials, including peroxides and amines. Methods of curing include press cure and autoclave cure. A wide range of cure conditions are possible, depending upon the time, temperature and pressure applied during cure.. Other components that affect the cure schedule are polymer blend, cure system, acid acceptor, filler system and part configuration.

The thermal interface material of the invention preferably comprises between about 2 to about 30 volume % acrylic polymer and between about 2 to about 30 volume % of one or more liquid resins. The thermal interface material of the invention most preferably comprises between about 2 to about 20 volume % of the acrylic polymer and between about 2 to about 20 volume % of one or more liquid resins and between about 2 to about 20 volume % acrylate. The material preferably comprises in the range of about 15 to about 95 weight % conductive particles.

In addition to the ingredients set out above, additives may be included in the formulation to provide desired properties. One of the most advantageous properties provided by additives is improved handling. In particular, materials that are solid at room temperature, such as phenol formaldehyde, phenolics, waxes, epoxy, thermoplastics and acrylics are advantageous for providing improved handling. Various additives that may be included are surface active agents, surfactants, diluents, wetting agents, antioxidants, thixotropes, reinforcement materials, silane functional perfluoroether, phosphate functional perfluoroether, silanes, titanates, wax, phenol formaldehyde, epoxy and other low molecular weight polymers that offer surface affinity and polymer compatibility.

Figure 1 illustrates an electronic component 10 utilizing two layers of thermal interface materials. Electronic component 10 comprises a substrate 11 that is attached to a silicon die 12 via interconnects 14. The silicon die generates heat that is transferred through thermal interface film 15 that is adjacent at least one side of the die. Heat spreader 16 is positioned adjacent to the thermal interface film and acts to dissipate a portion of the heat that passes through the first thermal interface material layer. Cold sink 17 is positioned adjacent to the heat spreader to dissipate any transferred thermal energy. A thermal interface film-pad 18 is located between the heat spreader and the cold sink. The thermal interface film-pad 18 is commonly thicker than the thermal interface film 15.

The invention is further illustrated by the following non-limiting example:
Example 1: A thermal interface material (Formulation A) was formulated as shown Table 1 (all percents are in weight percent). The acrylic polymer, solid epoxy, and acrylate rubber were dissolved in methyl ethyl ketone. Next, the ingredients were added stepwise into a mixing vessel. The mix vessel was placed under an air driven mixer and the materials were mixed for 20 minutes. Next, the materials were de-gassed and coated at 5 ft/min onto a silicone treated carrier substrate. Following the coating of the material, the film is dried at 75°C for 20 minutes to remove solvent.

**Table 1. Thermal Interface Formulation A**

| Material | Weight Percent |
|---|---|
| Acrylic Polymer¹ | 12 |
| Acrylate² | 12 |
| Liquid DGBEA³ | 10.4 |
| Solid Epoxy⁴ | 3.6 |
| Surface Agent⁵ | 1 |
| Surface Agent⁶ | 1 |
| Conductive Filler⁷ | 60 |

| | |
|---|---|
| ¹SG80H-DR ²AR-14 ³ARALDITE GY6010, commercially available from Vantico ⁴EPON 1001f, commercially available from Resolution ⁵FLUOROLINK F10, commercially available from Solvay Solexis ⁶FLUOROLINK S10, commercially available from Solvay Solexis ⁷boron nitride | |

Formulation A and various commercially available grease and pad thermal interface materials were tested for resistance. The thermal resistance was measured by the laser flash technique. Those skilled in the arts will be knowledgeable of the transient heating test method. In this method a sample is heated on one sample by a pulsed laser, and the heat flow is measured on the backside of the sample. Samples that have superior thermal performance will have a high thermal diffusivity (measured value). The thermal diffusivity is directly proportional to the thermal conductivity of the sample and inversely proportional the samples thermal resistance. The results of the testing are shown in Table 2.

**Table 2. Thermal Interface Resistance**

| Product | Thickness (mm) | Resistance (mm²-K/W)) |
|---|---|---|
| Formulation A | 0.14; 0.13; 0.12; 0.13 | 27; 13; 16; 18 |
| Grease¹ | 0.068 | 11.0 |
| Grease² | 0.049 | 42.0 |
| Grease³ | 0.094 | 39.0 |
| Pad⁴ | 0.25 | 70 |
| Pad⁵ | 0.2 | 80 |
| Pad⁶ | 0.18 | 220 |

| | | |
|---|---|---|
| ¹G751, commercially available from ^{Z}TC-4, commercially available from ³Wakefield 126, commercially available from ⁴Chomerics T-500, commercially available from ⁵Polymatech PT-H, commercially available from ⁶Denka M45, commercially available from | | |

As shown in Table 2, the resistance of the pad of the formulation of the present invention compares very favorable to the resistances of existing commercial thermal interface greases and pads.

## Claims

1. A thermally conductive composition for transferring heat, comprising acrylic polymer, one or more liquid 50 resins and optionally one or more solid resins, and in the range of **characterised in that** to 95wt% thermally conductive particles, the acrylic polymer is selected from the group consisting of butyl acrylate-ethyl acrylonitrile, butyl acrylate-co-ethyl acrylonitrile, ethyl acrylate-acrylonitrile and mixtures thereof.

2. The thermally conductive composition of claim 1, wherein the acrylic polymer has hydroxyl, carboxylic acid, isocyanate or epoxy functionality.

3. The thermally conductive composition of claim 1, wherein the acrylic polymer has a molecular weight in the range of about 200,000 to about 900,000.

4. The thermally conductive composition of claim 1, wherein the acrylic polymer has a Tg within the range of about 30°C to about -40°C.

5. The composition of claim 1, wherein the composition comprises in the range of about 2 weight % to about 20 weight % of the acrylic polymer.

6. The composition of claim 1, wherein the conductive particles comprise silver, gold, nickel, copper, metal oxides, boron nitride, alumina, magnesium oxides, zinc oxide, aluminum, aluminum oxide, aluminum nitride, silver-coated organic particles, silver plated nickel, silver plated copper, silver plated aluminum, silver plated glass, silver flakes, carbon black, graphite, boron nitride-coated particles and mixtures thereof.

7. The composition of claim 1, wherein the one or more liquid and solid resins are selected from the group consisting of monofunctional and multifunctional glycidyl ethers of Bisphenol-A and Bisphenol-F, aliphatic and aromatic epoxies, saturated and unsaturated epoxies, cycloaliphatic epoxy resins, bisphenol A epoxy resin, epoxy novolac resin, dicyclopentadiene-phenol epoxy resin, naphthalene resins, epoxy functional butadiene acrylonitrile copolymers, epoxy functional polydimethyl siloxane, epoxy functional copolymers, 3,4-epoxycyclohexylmethyl-3,4-epoxycyclohexane carboxylate, vinylcyclohexene dioxide, 3,4-epoxy-6-methyl cyclohexyl methyl-3,4-epoxycyclohexane carboxylate, dicyclopentadiene dioxide, poly(phenyl glycidyl ether)-co-formaldehyde, biphenyl type epoxy resin, dicyclopentadiene-phenol epoxy resins, naphthalene epoxy resins, epoxy functional butadiene acrylonitrile copolymers, epoxy functional polydimethyl siloxane, phenolic, acrylic, silicone, polyol, amine, rubber based, phenoxy, olefin, polyester, isocyanate, cyanate ester, bismaleimide and mixtures thereof.

8. The composition of claim 1, wherein the composition comprises in the range of about 2 weight % to about 30 weight % of the one or more liquid resins.

9. The composition of claim 1, further comprising one or more acrylates.

10. The composition of claim 1, further comprising one or more additives.

11. The composition of claim 7, wherein the additives are selected from the group consisting of surface active agents, antioxidants, surfactants, diluents, wetting agents, thixotropes, reinforcement materials, silane functional perfluoroether, phosphate functional perfluoroether, silanes, titanates, wax, phenol formaldehyde, epoxy, acrylic, low molecular weight polymers that offer surface affinity and polymer compatibility, and mixtures thereof.

12. The composition of claim 1, wherein the composition is in the form of a paste, supported or free-standing film.

13. The composition of claim 1, further comprising a pressure sensitive adhesive.

14. An electronic device comprising a heat-generating component, a cold sink and the thermally conductive composition of claim 1 providing a thermal interface between both.

15. An electronic device comprising a heat-generating component, a heat spreader and the thermally conductive composition of claim 1 providing a thermal interface between both.

## Patentansprüche

1. Wärmeleitfähige Zusammensetzung zur Übertragung von Wärme, die Acrylpolymer, ein oder mehrere Flüssigharze und gegebenenfalls ein oder mehrere Festharze und im Bereich von 50 bis 95 Gew.-% wärmeleitfähige Teilchen enthält,
**dadurch gekennzeichnet, dass** das Acrylpolymer aus der Gruppe bestehend aus Butylacrylat/Ethylacrylnitril, Butylacrylat-co-Ethylacrylnitril, Ethylacrylat/Acrylnitril und Gemischen davon ausgewählt ist.

2. Wärmeleitfähige Zusammensetzung nach Anspruch 1, wobei das Acrylpolymer Hydroxyl-, Carbonsäure-, Isocyanat- oder Epoxyfunktionalität aufweist.

3. Wärmeleitfähige Zusammensetzung nach Anspruch 1, wobei das Acrylpolymer ein Molekulargewicht im Bereich von etwa 200.000 bis etwa 900.000 aufweist.

4. Wärmeleitfähige Zusammensetzung nach Anspruch 1, wobei das Acrylpolymer eine Tg im Bereich von etwa 30 °C bis etwa -40 °C aufweist.

5. Zusammensetzung nach Anspruch 1, wobei die Zusammensetzung das Acrylpolymer im Bereich von etwa 2 Gew.-% bis etwa 20 Gew.-% umfasst.

6. Zusammensetzung nach Anspruch 1, wobei die leitfähigen Teilchen Silber, Gold, Nickel, Kupfer, Metalloxide, Bornitrid, Tonerde, Magnesiumoxide, Zinkoxid, Aluminium, Aluminiumoxid, Aluminiumnitrid, silberbeschichtete organische Teilchen, versilbertes Nickel, versilbertes Kupfer, versilbertes Aluminium, versilbertes Glas, Silberflocken, Ruß, Graphit, bornitridbeschichtete Teilchen und Gemische davon umfassen.

7. Zusammensetzung nach Anspruch 1, wobei das eine oder die mehreren Flüssig- und Festharze aus der Gruppe bestehend aus monofunktionellen und polyfunktionellen Glycidylethern von Bisphenol A und Bisphenol F, aliphatischen und aromatischen Epoxidharzen, gesättigten und ungesättigten Epoxidharzen, cycloaliphatischen Epoxidharzen, Bisphenol-A-Epoxidharz, Epoxynovolakharz, Dicyclopentadienphenolepoxidharz, Naphthalinharzen, epoxyfunktionellen Butadien/Acrylnitril-Copolymeren, epoxyfunktionellen Polydimethylsiloxan, epoxyfunktionellen Copolymeren, 3,4-Epoxycyclohexylmethyl-3,4-epoxycyclohexancarboxylat, Vinylcyclohexendioxid, 3,4-Epoxy-6-methylcyclohexylmethyl-3,4-epoxycyclohexancarboxylat, Dicyclopentadiendioxid, Poly(phenylglycidylether)-co-Formaldehyd, Epoxidharz vom Biphenyltyp, Dicyclopentadienphenolepoxidharzen, Naphthalinepoxidharzen, epoxyfunktionellen Butadien/Acrylnitril-Copolymeren, epoxyfunktionellem Polydimethylsiloxan, Phenol-, Acryl-, Silikon-, Polyol-, Amin-, kautschukbasierten, Phenoxy-, Olefin-, Polyester-, Isocyanat-, Cyanatester-, Bismaleinimidharzen und Gemischen davon ausgewählt ist.

8. Zusammensetzung nach Anspruch 1, wobei die Zusammensetzung das eine oder die mehreren Flüssigharze im Bereich von etwa 2 Gew.-% bis etwa 30 Gew.-% umfasst.

9. Zusammensetzung nach Anspruch 1, die weiterhin ein oder mehrere Acrylate umfasst.

10. Zusammensetzung nach Anspruch 1, die weiterhin ein oder mehrere Additive umfasst.

11. Zusammensetzung nach Anspruch 7, wobei die Additive aus der Gruppe bestehend aus oberflächenaktiven Stoffen, Antioxidationsmitteln, Tensiden, Verdünnungsmitteln, Benetzungsmitteln, Thixotropen, Verstärkungsmaterialien, silanfunktionellem Perfluorether, phosphatfunktionellem Perfluorether, Silanen, Titanaten, Wachs, Phenolformaldehyd, Epoxidharz, Acrylharz, niedermolekularen Polymeren, die Oberflächenaffinität und Polymerverträglichkeit bieten, und Gemischen davon ausgewählt sind.

12. Zusammensetzung nach Anspruch 1, wobei die Zusammensetzung in der Form einer Paste, eines getragenen oder freistehenden Films ist.

13. Zusammensetzung nach Anspruch 1, die weiterhin einen Haftkleber umfasst.

14. Elektronisches Gerät, das ein Wärme erzeugendes Bauteil, eine Kältesenke und die wärmeleitfähige Zusammensetzung nach Anspruch 1 umfasst, wodurch eine thermische Grenzfläche zwischen beiden bereitgestellt wird.

15. Elektronisches Gerät, das ein Wärme erzeugendes Bauteil, einen Wärmeverteiler und die wärmeleitfähige Zusammensetzung nach Anspruch 1 umfasst, wodurch eine thermische Grenzfläche zwischen beiden bereitgestellt wird.

## Revendications

1. Composition thermoconductrice pour le transfert de chaleur, comprenant un polymère acrylique, une ou plusieurs résines liquides et éventuellement une ou plusieurs résines solides, et entre 50 et 95 % en poids de particules thermoconductrices, **caractérisée en ce que** le polymère acrylique est choisi dans le groupe constitué de l'acrylate de butyle-éthylacrylonitrile, de l'acrylate de butyle-co-éthylacrylonitrile, de l'acrylate d'éthyle-acrylonitrile, et de leurs mélanges.

2. Composition thermoconductrice selon la revendication 1, dans laquelle le polymère acrylique a une fonctionnalité hydroxyle, acide carboxylique, isocyanate ou époxy.

3. Composition thermoconductrice selon la revendication 1, dans laquelle le polymère acrylique a un poids moléculaire compris entre environ 200 000 et environ 900 000.

4. Composition thermoconductrice selon la revendication 1, dans laquelle le polymère acrylique a une température de transition vitreuse, Tg, qui se situe dans la plage d'environ 30 °C à environ -40 °C.

5. Composition selon la revendication 1, ladite composition comprenant environ 2 % en poids à environ 20 % en poids du polymère acrylique.

6. Composition selon la revendication 1, dans laquelle les particules conductrices comprennent de l'argent, de l'or, du nickel, du cuivre, des oxydes métalliques, du nitrure de bore, de l'alumine, des oxydes de magnésium, de l'oxyde de zinc, de l'aluminium, de l'oxyde d'aluminium, du nitrure d'aluminium, des particules organiques revêtues d'argent, du nickel revêtu d'argent, du cuivre revêtu d'argent, de l'aluminium revêtu d'argent, du verre revêtu d'argent, des paillettes d'argent, du noir de carbone, du graphite, des particules revêtues de nitrure de bore, et des mélanges de ceux-ci.

7. Composition selon la revendication 1, dans laquelle la ou les résines liquides et solides sont choisies dans le groupe constitué des éthers glycidyliques monofonctionnels et multifonctionnels du bisphénol A et du bisphénol F, des résines époxydes aliphatiques et aromatiques, des résines époxydes saturées et insaturées, des résines époxydes cycloaliphatiques, d'une résine époxyde de bisphénol A, d'une résine époxyde novolaque, d'une résine époxyde de dicyclopentadiène-phénol, des résines de naphtalène, des copolymères d'acrylonitrile-butadiène à fonction époxy, du polydiméthylsiloxane à fonction époxy, des copolymères à fonction époxy, du 3,4-époxycyclohexane-carboxylate de 3,4-époxycyclohexylméthyle, du dioxyde de vinylcyclohexène, du 3,4-époxycyclohexane-carboxylate de 3,4-époxy-6-méthylcyclohexyle, du dioxyde de dicyclopentadiène, du poly(éther phénylglycidylique)-co-formaldéhyde, d'une résine époxyde de type biphényle, des résines époxydes de dicyclopentadiène-phénol, des résines époxydes de naphtalène, des copolymères de butadiène-acrylonitrile à fonction époxy, du polydiméthylsiloxane à fonction époxy, des résines phénoliques, acryliques, de silicone, de polyol, d'amine, à base de caoutchouc, phénoxy, oléfiniques, polyesters, isocyanates, esters de cyanate, bismaléimides, et leurs mélanges.

8. Composition selon la revendication 1, ladite composition comprenant entre environ 2 % en poids et environ 30 % en poids d'une ou plusieurs résines liquides.

9. Composition selon la revendication 1, comprenant en outre un ou plusieurs acrylates.

10. Composition selon la revendication 1, comprenant en outre un ou plusieurs additifs.

11. Composition selon la revendication 7, dans laquelle les additifs sont choisis dans le groupe constitué des agents de surface, des anti-oxydants, des tensioactifs, des diluants, des agents mouillants, des agents thixotropes, des matériaux de renfort, d'un perfluoroéther à fonction silane, d'un perfluoroéther à fonction phosphate, des silanes, des titanates, de la cire, d'une résine de phénol-formaldéhyde, d'une résine époxyde, d'une résine acrylique, des polymères de bas poids moléculaire qui présentent une affinité pour les surfaces et une compatibilité des polymères, et leurs mélanges.

12. Composition selon la revendication 1, ladite composition se présentant sous la forme d'une pâte, d'un film sur support ou autoportant.

13. Composition selon la revendication 1, comprenant en outre un adhésif sensible à la pression.

14. Dispositif électronique comprenant un composant générateur de chaleur, un puits froid et la composition thermoconductrice selon la revendication 1 assurant une interface thermique entre les deux.

15. Dispositif électronique comprenant un composant générateur de chaleur, un dissipateur de chaleur et la composition thermoconductrice selon la revendication 1 assurant une interface thermique entre les deux.
